# EUROPÄISCHE PATENTSCHRIFT

(11) **EP 1 668 058 B1**
(45) Veröffentlichungstag und Bekanntmachung des Hinweises auf die Patenterteilung: **24.10.2012**
(21) Anmeldenummer: 04765395.1
(22) Anmeldetag: 18.09.2004
(51) Int. Cl.: C08G 61/02, C08G 61/10, C08G 61/00, H01L 51/00

(54) **KONJUGIERTE POLYMERE, DEREN DARSTELLUNG UND VERWENDUNG**
CONJUGATED POLYMERS, THEIR PREPARATION AND USE THEREOF
POLYMERES CONJUGUES, LEUR REPRESENTATION ET LEUR UTILISATION

(30) Priorität: 20.09.2003 DE 10343606; 05.12.2003 DE 10357317
(43) Veröffentlichungstag der Anmeldung: 14.06.2006
(73) Patentinhaber: Merck Patent GmbH, 64293 Darmstadt (DE)
(72) Erfinder: FALCOU, Aurélie, Dr., 60322 Frankfurt (DE); MEYER, Frank, Dr., 69120 Heidelberg (DE); PARHAM, Amir, Dr., 65929 Frankfurt (DE); BECKER, Heinrich, Dr., 65719 Hofheim (DE)
(86) Internationale Anmeldenummer: PCT/EP2004/010505
(87) Internationale Veröffentlichungsnummer: WO 2005/030828

(56) Entgegenhaltungen:
- WO-A-02/077060
- WO-A-03/020790

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423283 offenbart sind. Seit kurzem ist ein erstes, wenn auch einfaches, Produkt (eine kleine Anzeige in einem Rasierapparat der Fa. PHILIPS N.V.) auf dem Markt erhältlich. Allerdings sind immer noch deutliche Verbesserungen der verwendeten Materialien nötig, um diese Displays zu einer echten Konkurrenz zu den derzeit marktbeherrschenden Flüssigkristallanzeigen (LCD) zu machen bzw. diese zu überflügeln.

Dabei ist es für die Erzeugung aller drei Emissionsfarben notwendig, bestimmte Comonomere in die entsprechenden Polymere einzupolymerisieren (vgl. z. B. WO 00/46321, WO 03/020790 und WO 02/077060). So ist dann in der Regel, ausgehend von einem blau emittierenden Grundpolymer ("backbone"), die Erzeugung der beiden anderen Primärfarben Rot und Grün möglich.

Die konjugierten Polymere gemäß dem Stand der Technik zeigen zum Teil schon gute Eigenschaften in der Anwendung in PLEDs. Trotz der erzielten Fortschritte entsprechen sie allerdings noch nicht den Anforderungen, die an sie für eine unproblematische Verarbeitung und für hochwertige Anwendungen gestellt werden. So ist die Stabilität vieler Polymere gemäß dem Stand der Technik gegenüber Sauerstoff und/oder anderen Luftbestandteilen noch keineswegs zufriedenstellend, d. h. die Polymere zeigen nach Kontakt mit Luft deutlich schlechtere Eigenschaften in PLEDs. Als Folge verringern sich die Effizienz und die Lebensdauer der Polymere drastisch. Dies macht die Verarbeitung der Polymere und die Herstellung der PLEDs unter inerten Bedingungen notwendig, was einen erheblichen Mehraufwand und somit einen technologischen Nachteil darstellt. Es wäre wünschenswert, Polymere zur Verfügung zu haben, die stabil gegenüber Luft sind, deren weitere Eigenschaften im Device jedoch unverändert gut oder besser sind als die der Polymere gemäß dem Stand der Technik. Weiterhin ist es nötig, Polymere zu entwickeln, deren Betriebsspannung bei der Verwendung in OLEDs reduziert werden kann. Dies ist nötig, um die Leistungseffizienz der OLEDs zu erhöhen.

Es wurde nun überraschend gefunden, dass eine neue Polymerklasse, die zum einen ein bestimmtes Polymergrundgerüst, zum anderen bestimmte substituierte Dithienylaryleneinheiten enthalten, sehr gute und den o. g. Stand der Technik übertreffende Eigenschaften aufweist. Insbesondere sind diese Polymere weitestgehend inert gegenüber Luft. Weiterhin zeigen sie eine gute Effizienz und Lebensdauer bei der Verwendung in PLEDs und sind gut löslich in einer großen Reihe organischer Lösemittel. Vor allem ist auch die Betriebsspannung der Polymere niedriger im Vergleich zu Polymeren gemäß dem Stand der Technik; ebenso wie der Spannungsanstieg bei längerem Betrieb. Diese Polymere und deren Verwendung in PLEDs sind daher Gegenstand der vorliegenden Erfindung.

Die Verwendung unsubstituierter und substituierter Dithienylaryleneinheiten in konjugierten Polymeren für die Elektrolumineszenz ist in der Literatur bereits beschrieben. Diese Publikationen beziehen sich jedoch vor allem auf Homopolymere dieser Einheiten (z. B. J. Pei et al., Macromolecules 2000, 33, 2462; J. Pei et al., Macromolecules 2001, 34, 7241). Durch Einführung der Aryleneinheiten konnte die Photolumineszenzquantenausbeute gegenüber reinen Polythiophenen gesteigert werden. Dass diese Polymere dennoch nicht für die Elektrolumineszenz geeignet sind, zeigen die PLED-Ergebnisse, die mit diesen Polymeren erhalten wurden: Die Einsatzspannungen sind höher als 8 V, je nach Polymer und Devicekonfiguration sogar bis zu 20 V, und die externen Quanteneffizienzen liegen im Bereich von 0.05 bis 0.6 %, teils sogar noch viel geringer. Sowohl die Spannungen als auch die Quanteneffizienzen liegen damit deutlich hinter dem Stand der Technik zurück, und es ist offensichtlich, dass die höhere PL-Quantenausbeute nicht zu befriedigenden EL-Effizienzen beiträgt. Diese Polymere sind also ungeeignet für die kommerzielle Anwendung in PLEDs.

Weiterhin bekannt sind Copolymere dieser Einheit mit Phenyleneinheiten. Dadurch ergeben sich alternierende Thienylen-Phenylen-Polymere (z. B. J. M. Xu et al., Macromolecules 2001, 34, 4314). Ergebnisse dieser Polymere in der Elektrolumineszenz werden nicht gezeigt; es kann jedoch aus der Beschreibung abgeleitet werden, dass sich diese Polymere nicht für die Elektrolumineszenz eignen. So wird für einige Derivate beschrieben, dass sie starke Interaktion der Polymerketten zeigen, was in einer Verschiebung der Fluoreszenzwellenlänge resultiert. Solche Emissionsbanden zeigen häufig eine sehr geringe Effizienz. Außerdem konnten diese Polymere nur mit einem niedrigen Molekulargewicht hergestellt werden, was für die technische Anwendung, z. B. die Verarbeitung durch Drucktechniken, unbrauchbar ist. Zudem sind die Polymere nur sehr schlecht löslich in Lösemitteln wie Toluol oder Xylol, die üblicherweise für die Verarbeitung der Polymere aus Lösung verwendet werden. Die Herstellung von PLEDs mit diesen Polymeren wird daher mit erheblichen Schwierigkeiten verbunden, bzw. nur in schlechter Qualität möglich sein.

Copolymere aus *unsubstituierten* Dithienylphenylen- bzw. Dithienylanthryleneinheiten mit Spirobifluorenen und weiteren Comonomeren wurden in WO 03/020790 als Beispiele gezeigt. Besondere Vorteile dieser Einheiten werden nicht angeführt. Jedoch zeigen sich bei Polymeren, die diese Einheiten enthalten, Probleme bei der Synthese und Verarbeitung durch die schlechte Löslichkeit der Oligomere und Polymere. So ist die Synthese häufig nicht in homogener Lösung möglich, die Aufarbeitung ist erschwert, ebenso die Herstellung von Lösungen dieser Polymere, und in der Verwendung in PLEDs erhält man keine homogenen Filme der Polymere. Dies ist insbesondere der Fall, wenn ein höherer Anteil dieser Monomere in die Polymere einpolymerisiert wird, wie dies für die elektrooptischen Eigenschaften des Polymers (Farbe, Effizienz, Lebensdauer) wünschenswert wäre. Eine Verarbeitung dieser Polymere durch Drucktechniken, z. B. InkJet Printing (Tintenstrahldruck), ist so nur schwierig oder überhaupt nicht möglich. Aus dieser Anmeldung ist nicht ersichtlich, wie man mit diesen Einheiten gut lösliche Polymere mit guten elektrooptischen Eigenschaften entwickeln könnte.

Gegenstand der Erfindung sind Polymere, enthaltend mindestens 5 mol%, bevorzugt mindestens 10 mol%, besonders bevorzugt mindestens 40 mol% Einheiten gemäß Formel (1). 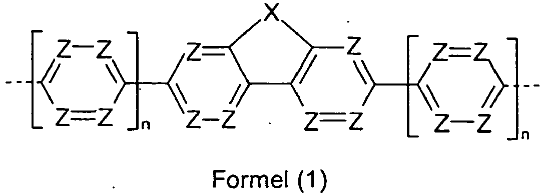 wobei die verwendeten Symbole folgende Bedeutung besitzen:
- X: ist bei jedem Auftreten gleich oder verschieden CR₂, N(R¹), -CR₂-CR₂- oder -N(R¹)-CR₂-,
- Z: ist bei jedem Auftreten gleich oder verschieden CR oder N;
- R: ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch -N(R¹)-, -O-, -S-, -O-CO-O-, -CO-O-, C=O, -C(R¹)=C(R¹)- oder -C≡C- ersetzt sein können, wobei auch ein oder mehrere H-Atome durch Fluor oder eine aromatische Gruppe R¹ ersetzt sein können, eine aromatisches oder heteroaromatisches Ringsystem oder eine Aryloxygruppe mit 5 bis 40 C-Atomen, bei denen auch ein oder mehrere C-Atome durch O, S oder N ersetzt sein können und welche auch durch einen oder mehrere nicht-aromatische Reste R substituiert sein können, wobei auch zwei oder mehrere der Reste R miteinander ein aromatisches oder aliphatisches, mono- oder polycyclisches Ringsystem bilden können, oder Fluor, Chlor, CN, N(R¹)₂, Si(R¹)₃ oder B(R¹)₂;
- R¹: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch -O-, -S-, -CO-O-, -O-CO-O-, C=O, -CH=CH - oder -C≡C- ersetzt sein können, wobei auch ein oder mehrere H-Atome durch Fluor ersetzt sein können, eine Aryl-, Heteroaryl- oder Aryloxygruppe mit 5 bis 40 C-Atomen, bei der auch ein oder mehrere C-Atome durch O, S oder N ersetzt sein können, welche auch durch einen oder mehrere nicht-aromatische Reste R¹ substituiert sein können, wobei auch ein oder mehrere Reste R¹ oder R¹ mit weiteren Resten R miteinander ein aromatisches oder aliphatisches, mono- oder polycyclisches Ringsystem bilden kann;
- n: ist bei jedem Auftreten gleich oder verschieden 0 oder 1;
dadurch gekennzeichnet, dass das Polymer weiterhin mindestens 0.01 mol%, bevorzugt mindestens 1 mol%, besonders bevorzugt mindestens 5 mol%, ganz besonders bevorzugt mindestens 10 mol% Einheiten gemäß Formel (2) enthält, 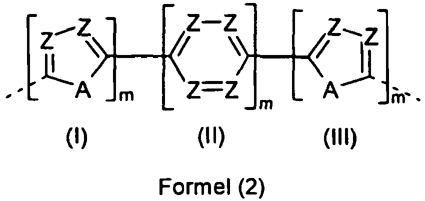 wobei für die Symbole und Indizes Folgendes gilt:
- A: ist bei jedem Auftreten gleich oder verschieden S, O oder N(R¹);
- Z: ist bei jedem Auftreten gleich oder verschieden CR oder N, mit der Maßgabe, dass die zentrale Einheit (II) kein Chinoxalin, kein Benzothiadiazol und kein unsubstituiertes Anthracen beschreibt und mit der weiteren Maßgabe, dass mindestens ein Rest R ungleich Wasserstoff ist;
- R: ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch -N(R')-, -O-, -S-, -O-CO-O-, -CO-O-, C=O, -C(R¹)=C(R¹)- oder -C≡C- ersetzt sein können, wobei auch ein oder mehrere H-Atome durch Fluor oder eine aromatische Gruppe R¹ ersetzt sein können, eine aromatisches oder heteroaromatisches Ringsystem oder eine Aryloxygruppe mit 5 bis 40 C-Atomen, bei denen auch ein oder mehrere C-Atome durch O, S oder N ersetzt sein können und welche auch durch einen oder mehrere nicht-aromatische Reste R substituiert sein können, wobei auch zwei oder mehrere der Reste R miteinander ein aliphatisches, mono- oder polycyclisches Ringsystem bilden können, oder Fluor, Chlor, CN, N(R¹)₂, Si(R¹)₃ oder B(R¹)₂;
- m: ist bei jedem Auftreten gleich oder verschieden 1, 2 oder 3;
die weiteren Symbole sind wie unter Formel (1) beschrieben;
die gestrichelte Bindung bedeutet dabei in Formel (1) und Formel (2) ebenso wie in allen weiteren Formeln die Verknüpfung im Polymer; sie soll hier keine Methylgruppe darstellen.

Auch wenn dies aus der Beschreibung hervorgeht, sei hier explizit darauf verwiesen, dass die Struktureinheiten gemäß Formel (1) und Formel (2) auch unsymmetrisch substituiert sein können, d. h. dass an einer Einheit unterschiedliche Substituenten R bzw. R¹ vorhanden sein können. Außerdem können in einem Polymer auch verschiedene Einheiten gemäß Formel (1) und/oder Formel (2) vorhanden sein.

Ebenso sei hier nochmals explizit darauf verwiesen, dass die Reste R miteinander ein Ringsystem bilden können. Dies gilt insbesondere auch für die Reste R an der Position X, so dass ausdrücklich beispielsweise auch Spirosysteme, insbesondere Spirobifluoren, mit eingeschlossen sind. Ebenso sind dadurch ausgedehntere überbrückte Systeme, wie beispielsweise cis- oder trans-Indenofluorene oder verwandte Strukturen möglich.

Die erfindungsgemäßen Polymere können konjugiert, teilkonjugiert oder nicht-konjugiert sein. In einer bevorzugten Ausführungsform der Erfindung sind die Polymere konjugiert oder teilkonjugiert, in einer besonders bevorzugten Ausführungsform sind die Polymere konjugiert.

Konjugierte Polymere im Sinne dieser Erfindung sind Polymere, die in der Hauptkette hauptsächlich sp²-hybridisierte (oder auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich (unwillkürlich) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden. Hingegen würden Einheiten wie beispielsweise einfache (Thio)Etherbrücken, Alkylenbrücken, Ester-, Amid- oder Imidverknüpfungen eindeutig als nicht-konjugierte Segmente definiert. Unter teilkonjugierten Polymeren im Sinne dieser Erfindung werden Polymere verstanden, in denen längere konjugierte Abschnitte in der Hauptkette durch nicht-konjugierte Abschnitte unterbrochen sind, oder Polymere, die längere konjugierte Einheiten in den Seitenketten eines in der Hauptkette nicht konjugierten Polymers enthalten.

Die erfindungsgemäßen Polymere können neben Einheiten gemäß den Formeln (1) und (2) noch weitere Strukturelemente enthalten. Dies sind u. a. solche, wie sie in den Patentanmeldungen WO 02/077060 und DE 10337346.2 bereits offenbart sind. Die weiteren Struktureinheiten können beispielsweise aus den im Folgenden beschriebenen Klassen stammen:
- Gruppe 1:: Einheiten, welche die Lochinjektions- und/oder -transporteigenschaften der Polymere deutlich erhöhen;
- Gruppe 2:: Einheiten, welche die Elektroneninjektions- und/oder -transporteigenschaften der Polymere deutlich erhöhen;
- Gruppe 3:: Einheiten, die Kombinationen von Einzeleinheiten der Gruppe 1 und Gruppe 2 aufweisen;
- Gruppe 4:: Einheiten, welche die Morphologie oder gegebenenfalls auch die Emissionsfarbe der Polymere beeinflussen.

Strukturelemente aus Gruppe 1, die Lochtransporteigenschaften aufweisen, sind im Allgemeinen Arylaminderivate oder elektronenreiche Heterocyclen, wie beispielsweise Triarylaminderivate, Benzidinderivate, Tetraarylen-para-phenylendiaminderivate, Phenothiazinderivate, Phenoxazinderivate, Dihydrophenazinderivate, Thianthrenderivate, Dibenzo-p-dioxinderivate, Phenoxathünderivate, Carbazolderivate, Azulenderivate, Thiophenderivate, Pyrrolderivate, Furanderivate und weitere O-, S- oder N-haltige Heterocyclen mit hoch liegendem HOMO (HOMO = höchst liegendes besetztes Molekülorbital); bevorzugt führen diese Einheiten zu einem HOMO im Polymer von weniger als 5.8 eV (gegen Vakuumlevel), besonders bevorzugt von weniger als 5.5 eV.

Strukturelemente aus Gruppe 2, die Elektronentransporteigenschaften aufweisen, sind im Allgemeinen elektronenarme Heterocyclen, wie beispielsweise Pyridinderivate, Pyrimidinderivate, Pyridazinderivate, Pyrazinderivate, Triazinderivate, Anthracenderivate, Oxadiazolderivate, Benzothiadiazolderivate, Chinolinderivate, Chinoxalinderivate, Phenazinderivate, aber auch Triarylborane und weitere O-, S- oder N-haltige Heterocyclen mit niedrig liegendem LUMO (LUMO = niedrigstes unbesetztes Molekülorbital); bevorzugt führen diese Einheiten im Polymer zu einem LUMO von mehr als 2.7 eV (gegen Vakuumlevel), besonders bevorzugt von mehr als 3.0 eV.

Es kann ebenfalls bevorzugt sein, wenn die erfindungsgemäßen Polymere Einheiten aus Gruppe 3 enthalten, in denen Einheiten, welche die Lochtransporteigenschaften und welche die Elektronentransporteigenschaften erhöhen, also Einheiten aus Gruppe 1 und Gruppe 2, direkt aneinander gebunden sind. Solche Einheiten führen im Polymer häufig zu Farbverschiebungen ins Gelbe oder Rote.

Es können auch weitere Strukturelemente vorhanden sein, die in Gruppe 4 zusammengefasst werden. Diese Einheiten können die Morphologie oder gegebenenfalls auch die Emissionsfarbe der Polymere beeinflussen. Dies sind Einheiten, die mindestens noch eine weitere aromatische oder andere konjugierte Struktur aufweisen, welche nicht unter die o. g. Gruppen fällt. Bevorzugt sind dabei aromatische, carbocyclische Strukturen, die 6 bis 40 C-Atome aufweisen, oder auch Stilben- oder Bisstyrylarylenderivate, die jeweils mit einem C₁ bis C₄₀ organischen Rest substituiert oder unsubstituiert sein können. Besonders bevorzugt ist dabei der Einbau von 1,4-Phenylen-, 1,4-Naphthylen-, 1,4- oder 9,10-Anthrylen-, 1,6- oder 2,7- oder 4,9-Pyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 5,7-Dihydrodibenzooxepinylen-, 4,4'-Stilbenylen- oder 4,4"-Bisstyrylarylenderivaten.

Weiterhin ist es ebenfalls möglich, Metallkomplexe einzubauen, die aus dem Singulett- oder aus dem Triplettzustand Licht emittieren können oder die auch andere Funktionen erfüllen können.

Es kann ebenfalls bevorzugt sein, wenn gleichzeitig mehr als eine Struktureinheit aus einer der genannten Gruppen vorliegt bzw. mehr als eine Struktureinheit gemäß Formel (1) und/oder Formel (2) vorliegt.

Die erfindungsgemäßen Polymere weisen in der Regel 10 bis 10000, bevorzugt 20 bis 5000, besonders bevorzugt 50 bis 2000 Wiederholeinheiten auf.

Die nötige Löslichkeit der Polymere wird v. a durch die Substituenten R gewährleistet, sowohl an Einheiten gemäß Formel (1) und (2), wie auch an weiteren gegebenenfalls vorhandenen Einheiten. Falls Substituenten R¹ vorhanden sind, tragen auch diese zur Löslichkeit bei.

Um ausreichende Löslichkeit zu gewährleisten, ist es bevorzugt, dass im Durchschnitt pro Wiederholeinheit mindestens 2 nicht-aromatische C-Atome in den Substituenten vorhanden sind. Bevorzugt sind dabei mindestens 4, besonders bevorzugt mindestens 8 nicht-aromatische C-Atome. Einzelne dieser C-Atome können auch durch O oder S ersetzt sein. Dies kann aber durchaus bedeuten, dass ein gewisser Anteil von Wiederholeinheiten, sowohl gemäß den Formeln (1) und (2) als auch anderer Strukturtypen, keine weiteren nicht-aromatischen Substituenten trägt. Für eine gute Löslichkeit des Polymers ist es jedoch notwendig, dass die Einheiten gemäß Formel (2) mindestens einen aromatischen oder bevorzugt nicht-aromatischen Substituenten tragen.

Um die Morphologie des Films nicht zu verschlechtern, ist es bevorzugt, keine langkettigen Substituenten mit mehr als 12 C-Atomen in einer linearen Kette zu haben, bevorzugt keine mit mehr als 8 C-Atomen, besonders bevorzugt keine mit mehr als 6 C-Atomen. Nicht-aromatische C-Atome sind, wie beispielsweise in der Beschreibung für R oder R¹ in Formeln (1) und (2), in entsprechenden geradkettigen, verzweigten oder cyclischen Alkyl - oder Alkoxyketten enthalten.

In einer bevorzugten Ausführungsform der Erfindung gilt für Struktureinheiten gemäß Formel (1) Z = CR und n = 0. Besonders bevorzugt gilt hierfür Z = CH und n = 0. Weiterhin bevorzugt gilt für die Gruppe X = CR₂ oder CR₂-CR₂. Ganz besonders bevorzugt sind diese Struktureinheiten ausgewählt aus den Gruppen der Fluorene gemäß Formel (3), der mit einem C₁ bis C₄₀ organischen Rest substituierten oder unsubstituierten 9,9'-Spirobifluorene gemäß Formel (4) oder der Dihydrophenanthrene gemäß Formel (5):

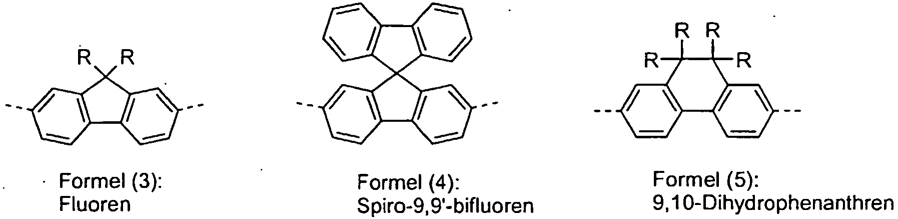

Weiterhin bevorzugt sind auch erweiterte Strukturen, bei denen mindestens ein n = 1 ist. Bevorzugte Strukturen sind cis- oder trans-Indenofluorene gemäß Formeln (6) und (7):

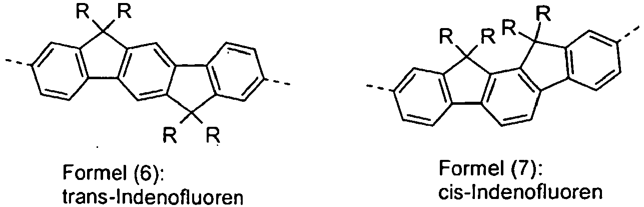

Dabei haben die verwendeten Symbole R und R¹ dieselbe Bedeutung, wie oben unter Formel (1) beschrieben.

Es hat sich gezeigt, dass ein Anteil von mindestens 5 mol%, bevorzugt ein Anteil von mindestens 10 mol%, besonders bevorzugt ein Anteil von mindestens 40 mol% Einheiten gemäß Formel (1) gute Ergebnisse liefert.

Weiterhin bevorzugt sind Polymere, bei denen für Einheiten gemäß Formel (2) Folgendes gilt:
- Z: ist bei jedem Auftreten gleich oder verschieden CR, wobei weiterhin die oben genannten Einschränkungen gelten;
- A: ist bei jedem Auftreten gleich oder verschieden O oder S;
- m: ist bei jedem Auftreten gleich oder verschieden 1 oder 2;
die weiteren Symbole sind wie oben unter Formel (2) definiert.

Besonders bevorzugt sind weiterhin Polymere, bei denen für Einheiten gemäß Formel (2) Folgendes gilt:
- Z: ist bei jedem Auftreten gleich oder verschieden CR, wobei weiterhin die oben genannten Einschränkungen gelten und mindestens zwei Reste R ungleich Wasserstoff sind;
- A: ist bei jedem Auftreten gleich S;
- R: ist wie oben unter Formel (1) definiert;
- R¹: ist wie oben definiert;
- m: ist bei jedem Auftreten gleich 1.

Es hat sich gezeigt, dass für grün oder rot emittierende Polymere ein Anteil von mindestens 1 mol%, bevorzugt mindestens 5 mol%, besonders bevorzugt mindestens 10 mol% Einheiten gemäß Formel (2) gute Ergebnisse liefert. Für weiß emittierende Copolymere, beispielsweise gemäß DE 10343606.5, kann jedoch auch ein kleinerer Anteil dieser Einheiten, insbesondere im Bereich von 0.01 bis 1 mol%, sehr gute Ergebnisse liefern.

Die erfindungsgemäßen Copolymere können statistische, alternierende oder blockartige Strukturen aufweisen. Wie Copolymere mit blockartigen Strukturen erhalten werden können, ist beispielsweise ausführlich in der nicht offen gelegten Anmeldung DE 10337077.3 beschrieben. Durch das Verwenden verschiedener Strukturelemente können Eigenschaften wie Löslichkeit, Festphasenmorphologie, Farbe, Ladungsinjektions- und -transporteigenschaften, optoelektronische Charakteristik, etc. eingestellt werden.

Bevorzugt sind erfindungsgemäße Polymere, die außer Struktureinheiten gemäß Formeln (1) und (2) noch mindestens eine Struktureinheit aus den Gruppen (1) bis (4) enthalten. Besonders bevorzugt ist dabei, wenn mindestens eine dieser Struktureinheiten Ladungstransporteigenschaften aufweist, also das Polymer Struktureinheiten aus Gruppe (1) und/oder (2) enthält. Der Anteil dieser Strukturelemente ist bevorzugt mindestens 1 mol%, besonders bevorzugt mindestens 5 mol%, ganz besonders bevorzugt mindestens 10 mol%. Der maximale Anteil dieser Strukturelemente ist bevorzugt höchstens 80 mol%, besonders bevorzugt höchstens 40 mol%.

Die erfindungsgemäßen Polymere werden durch Polymerisation mehrerer Monomere hergestellt, von denen mindestens eines Wiederholeinheiten gemäß Formel (1) und eines Wiederholeinheiten gemäß Formel (2) ergibt. Es haben sich hier einige Polymerisationsreaktionen besonders bewährt, die alle zu C-C-Verknüpfungen führen:
(A) Polymerisation gemäß SUZUKI;
(B) Polymerisation gemäß YAMAMOTO;
(C) Polymerisation gemäß STILLE.

Wie die Polymerisation nach diesen Methoden durchgeführt werden kann und wie die Polymere vom Reaktionsmedium abgetrennt und aufgereinigt werden können, ist beispielsweise im Detail beschrieben in der nicht offen gelegten Anmeldeschrift WO 04/037887.

Es kann auch bevorzugt sein, das erfindungsgemäße Polymer nicht als Reinsubstanz, sondern als Mischung (Blend) zusammen mit weiteren polymeren, oligomeren, dendritischen oder niedermolekularen Substanzen zu verwenden. Diese können beispielsweise den Loch - oder Elektronentransport verbessern oder das Ladungsgleichgewicht beeinflussen. Solche Blends sind daher auch Bestandteil der vorliegenden Erfindung.

Gegenstand der Erfindung sind weiterhin Lösungen und Formulierungen aus einem oder mehreren erfindungsgemäßen Polymeren oder Blends in einem oder mehreren Lösungsmitteln. Wie Polymerlösungen hergestellt werden können, ist beispielsweise in WO 02/072714, WO 03/019694 und der darin zitierten Literatur beschrieben.

Diese Lösungen können verwendet werden, um dünne Polymerschichten herzustellen, beispielsweise durch Flächenbeschichtungsverfahren (z. B. Spin-coating) oder durch Druckverfahren (z. B. InkJet Printing).

Die erfindungsgemäßen Polymere können in PLEDs verwendet werden. Wie PLEDs hergestellt werden können, wird als allgemeines Verfahren ausführlich in WO 04/037887 beschrieben, das entsprechend für den Einzelfall anzupassen ist.

Wie oben bereits beschrieben, eignen sich die erfindungsgemäßen Polymere ganz besonders als Elektrolumineszenzmaterialien in derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers oder Blends in einer PLED, insbesondere als Elektrolumineszenzmaterial. Dabei dient das erfindungsgemäße Polymer bzw. der Blend bevorzugt als emittierendes Material.

Gegenstand der Erfindung ist ebenfalls eine PLED mit einer oder mehreren aktiven Schichten, wobei mindestens eine dieser Schichten ein oder mehrere erfindungsgemäße Polymere oder Blends enthält. Die aktive Schicht kann beispielsweise eine lichtemittierende Schicht und/oder eine Ladungstransportschicht und/oder eine Ladungsinjektionsschicht sein.

Die erfindungsgemäßen Polymere weisen folgende Vorteile auf:
(1) Es wurde überraschend gefunden, dass die erfindungsgemäßen Polymere eine deutlich höhere Luftstabilität aufweisen als Polymere gemäß dem Stand der Technik. Dies gilt insbesondere für grün emittierende Copolymere. Dies ist von enormer Bedeutung, da somit die Verarbeitung der Polymere und der Herstellungsprozess der PLEDs deutlich vereinfacht werden kann. Während bisher für optimale Elektrolumineszenzergebnisse die Polymerfilme in einer inerten Atmosphäre erzeugt werden mussten, was einen erheblichen technologischen Mehraufwand bedeutet, können die Polymerfilme mit erfindungsgemäßen Polymeren an der Luft hergestellt, werden, ohne dass die Elektrolumineszenz darunter leidet.
(2) Vom Löslichkeitsverhalten (z. B. Gelierungstemperatur bei gegebener Konzentration, Viskosität bei gegebener Konzentration) zeigen die erfindungsgemäßen Polymere deutlich bessere Eigenschaften als Polymere, die unsubstituierte Einheiten gemäß Formel (2) enthalten. So weisen sie eine bessere Löslichkeit in einer größeren Bandbreite von Lösungsmitteln auf und neigen nicht zur Gelbildung. Dadurch lassen sich die Polymere leichter verarbeiten und bilden in der PLED homogenere Filme. Auch die Verarbeitung durch Drucktechniken, z. B. Tintenstrahldruck (InkJet Printing), wird so ermöglicht. Außerdem ist es dadurch möglich, einen höheren Anteil dieser Einheiten in das Polymer einzupolymerisieren, als dies mit unsubstituierten Einheiten möglich ist.
(3) Die Betriebsspannung der erfindungsgemäßen Polymere ist niedriger im Vergleich zu Polymeren gemäß dem Stand der Technik. Dies resultiert in einer höheren Leistungseffizienz.
(4) Der Spannungsanstieg bei längerem Betrieb ist deutlich geringer als bei Polymeren gemäß dem Stand der Technik.
(5) Des Weiteren hat sich gezeigt, dass im Vergleich zum Stand der Technik die erfindungsgemäßen, grün emittierenden Polymere vergleichbare oder höhere operative Lebensdauern aufweisen.
(6) Eine Kombination von Einheiten gemäß Formel (1) und (2) und eventuell weiteren Einheiten führt zu Polymeren, die grünes (oder je nach Comonomer auch rotes oder weißes) Licht mit sehr guten Farbkoordinaten emittieren. Dies stellt zwar keinen unmittelbaren Vorteil dar, da andere Polymere auch gute Farbkoordinaten aufweisen, ist jedoch eine entscheidende Voraussetzung für die Anwendung dieser Polymere. Insbesondere weisen erfindungsgemäße Polymere im Grünen bessere Farbkoordinaten auf als vergleichbare Polymere, die unsubstituierte Einheiten gemäß Formel (2) enthalten.

Im vorliegenden Anmeldetext und auch in den im Weiteren folgenden Beispielen wird auf die Verwendung erfindungsgemäßer Polymere oder Blends in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere oder Blends auch in anderen elektronischen Devices (Vorrichtungen) zu benutzen, z. B. in organischen Feld-Effekt-Transistoren (OFETs), in organischen Dünnfilmtransistoren (OTFTs), in organischen integrierten Schaltungen (O-ICs), in organischen Solarzellen (O-SCs) oder auch organischen Laserdioden (O-Laser), um nur einige Anwendungen zu nennen. Die Verwendung erfindungsgemäßer Polymere in den entsprechenden Vorrichtungen ebenso wie die Vorrichtungen selbst sind ebenfalls Gegenstand der vorliegenden Erfindung.

### Beispiele:

1,4-Dibrom-2,5-difluorbenzol wurde von Lancaster, 1,4-Dibrom-2,5-dimethoxybenzol und Thiophen-2-boronsäure von Aldrich kommerziell erhalten. 1,4-Dibrom-2,5-bis(pentoxy)benzol *(*Polymer 1997, 38, 1221-1226), 1,4-Dibrom-2,5-bis(iso-pentoxy)benzol (EP 1078970) und Benzol-1,4-bis(boronsäureglycolester) (J. Org. Chem. 1998, 63, 9535-9539) wurden gemäß der Literatur synthetisiert.

### Beispiel 1: Synthese von 1,4-disubstituierten 2,5-Bis(2'-thienyl)benzolderivaten

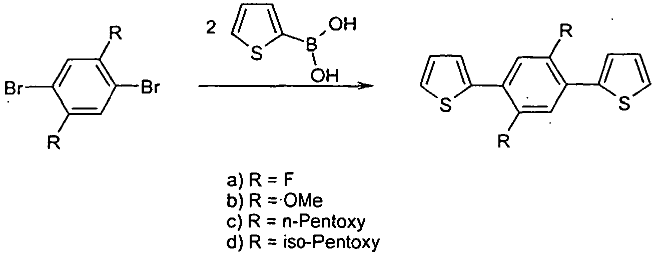

### Allgemeine Vorschrift:

Zu einer mit Stickstoff gesättigten Mischung aus 180 mmol des 2,5-disubstituierten 1,4-Dibrombenzolderivats, 60 g (469 mmol, 2.6 eq.) Thiophen-2-boronsäure, 149 g (702 mmol, 3.9 eq.) K₃PO₄, 1 L Dioxan und 1 L Wasser wurden 13.5 g (11.7 mmol, 0.065 eq.) Pd(PPh₃)₄ gegeben, und die Suspension wurde 7 h auf 80 °C erhitzt. Danach wurden 0.8 g NaCN zugegeben und die wässrige Phase abgetrennt. Die organische Phase wurde zweimal mit H₂O gewaschen und über Na₂SO₄ getrocknet.

### a) 2,5-Bis(2'-fhienyl)-1,4-difluorbenzol (R = F)

Nach zweimaliger Umkristallisation aus Toluol erhielt man gelbe Kristalle, die nach HPLC eine Reinheit von 99.8 % aufwiesen. Die Ausbeute betrug 44 g (88 %).

¹H-NMR (CDCl₃, 500 MHz): [ppm]= 8.14 (dd, ²J = 3.6 Hz, 2H), 7.41 (m, 4H), 7.52 (d, ²J = 3.6 Hz, 2H).

### b) 2,5-Bis(2'-thienyl)-1,4-dimethoxybenzol (R = OMe)

Nach zweimaliger Umkristallisation aus Ethylacetat erhielt man gelbe Kristalle, die nach HPLC eine Reinheit von 99.7 % aufwiesen. Die Ausbeute betrug 50 g (92 %).

¹H-NMR (CDCl₃, 500 MHz): [ppm]= 3.95 (s, 6H), 7.70 (dd, ²J = 5.3 Hz, ³J = 3.6 Hz, 2H), 7.25 (s, 2H), 7.35 (dd, ²J = 5.3 Hz, ³J = 1.0 Hz, 2H), 7.52 (dd, ²J = 3.6 Hz, ³J = 1.0 Hz, 2H).

### c) 1,4-Bis(n-pentoxy)-2,5-bis(2'-thienyl)benzol (R = n-Pentoxy)

Nach zweimaliger Umkristallisation aus Hexan erhielt man gelbe Kristalle, die nach HPLC eine Reinheit von 99.9 % aufwiesen. Die Ausbeute betrug 58 g (80 %).

¹H-NMR (CDCl₃, 500 MHz): [ppm]= 0.96 (t, ²J = 7.3 Hz, 6H), 1.40 (m, 4H), 1.51 (m, 4H), 1.91 (m, 4H), 4.08 (t, ²J = 6.7 Hz, 4H), 7.81 (dd, ²J = 5.0 Hz, ³J = 3.6 Hz, 2H), 7.26 (s, 2H), 7.36 (d, ²J = 5.0 Hz, 2H), 7.53 (d, ²J = 3.6 Hz, 2H).

### d) 1,4-Bis(iso-pentoxy)-2,5-bis(2'-thienyl)benzol (R = iso-Pentoxy)

Nach zweimaliger Umkristallisation aus Hexan erhielt man gelbe Kristalle, die nach HPLC eine Reinheit von 99.9 % aufwiesen. Die Ausbeute betrug 56 g (76 %).

¹H-NMR (CDCl₃, 500 MHz): [ppm]= 0.96 (d, ²J = 6.6 Hz, 12H), 1.82 (m, 4H), 1.97 (m, 2H), 4.12 (t, ²J = 5.3 Hz, 4H), 7.80 (dd, ²J = 5.0 Hz, ³J = 3.6 Hz, 2H), 7.26 (s, 2H), 7.35 (d, ²J = 5.0 Hz, 2H), 7.52 (d, ²J = 3.6 Hz, 2H).

### Beispiel 2: Synthese von 1,4-disubstituierten 2,5-Bis(5'-brom-2'-thienyl)benzolderivaten (Monomere T1 bis T4)

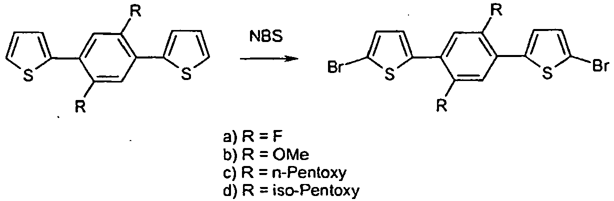

### Allgemeine Vorschrift:

Zu einer Lösung von 26 mmol des 1,4-disubstituierten 2,5-Bis(2'-thienyl)benzolderivats in 770 mL Chloroform wurden bei RT in einer Schutzgasatmosphäre und unter Lichtausschluss 9.51 g (54 mmol) N-Bromsuccinimid innerhalb 15 min. zugegeben. Die Mischung wurde 6 h gerührt, anschließend wurden 80 mL gesättigte Na₂CO₃-Lösung zugegeben, die organische Phase abgetrennt und über Na₂SO₄ getrocknet. Nach Entfernen des Lösemittels wurde der Rückstand umkristallisiert.

### a) 2,5-Bis(5'-brom-2'-thienyl)-1,4-difluorbenzol (R = F, Monomer T1)

Nach zweimaliger Umkristallisation aus DMF erhielt man gelbe Kristalle, die nach HPLC eine Reinheit von 99.9 % aufwiesen. Die Ausbeute betrug 12 g (92 %).

¹H-NMR (CDCl₃, 500 MHz): [ppm]= 7.08 (d, ²J = 3.6 Hz, 2H), 7.23 (d, ²J = 3.6 H, 2H), 7.35 (t, 9.0 Hz, 2H).

### b) 2,5-Bis(5'-brom-2'-thienyl)-1,4-dimethoxybenzol (R = OMe, Monomer T2)

Nach zweimaliger Umkristallisation aus Methanol erhielt man gelbe Kristalle, die nach HPLC eine Reinheit von 99.9 % aufwiesen. Die Ausbeute betrug 10 g (92 %).

¹H-NMR (CDCl₃, 500 MHz): [ppm]= 3.92 (s, 6H), 7.04 (d, ²J = 4 Hz, 2H), 7.17 (s, 2H), 7.23 (d, ²J = 4 Hz, 2H).

### c) 2,5-Bis(5'-brom-2'-thienyl)-1,4-bis(n-pentoxy)benzol (R = n-Pentoxy, Monomer T3)

Nach zweimaliger Umkristallisation aus Aceton erhielt man gelbe Kristalle, die nach HPLC eine Reinheit von 99.8 % aufwiesen. Die Ausbeute betrug 12 g (94 %).

¹H-NMR (CDCl₃, 500 MHz): [ppm]= 0.96 (t, ²J = 7.3 Hz, 6H), 1,41 (m, 4H), 1.51 (m, 4H), 1.91 (m, 4H), 4.08 (t, ²J = 6.7 Hz, 4H), 7.03 (d, ²J = 3.6 Hz, 2H), 7.15 (s, 2H), 7.24 (d, ²J = 3.6 Hz, 2H).

### d) 2,5-Bis(5'-brom-2'-thienyl)-1,4-bis(iso-pentoxy)benzol (R = iso-Pentoxy, Monomer T4)

Nach zweimaliger Umkristallisation aus Aceton erhielt man gelbe Kristalle, die nach HPLC eine Reinheit von 99.9 % aufwiesen. Die Ausbeute betrug 13 g (96 %).

¹H-NMR (CDCl₃, 500 MHz): [ppm]= 0.99 (d, ²J = 6.6 Hz, 12H), 1.82 (m, 4H), 1.97 (m, 2H), 4.12 (t, ²J = 5.3 Hz, 4H), 7.03 (d, ²J = 3.6 Hz, 2H), 7.16 (s, 2H), 7.24 (d, ²J = 3.6 Hz, 2H).

### Beispiel 3: Synthese von 3-Aryl-substituierten Thiophenderivaten

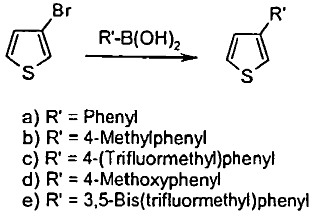

Die Synthese von 3-Phenylthiophen und 3-(4'-Methylphenyl)thiophen ist beschrieben in J. Org. Chem. 2000, 65, 352-359. Die Synthese von 3-(4'-Methoxyphenyl)thiophen und 3-[4'-(Trifluormethyl)phenyl]-thiophen ist beschrieben in J. Org. Chem. 2002, 67, 457-469.

### Allgemeine Vorschrift:

Zu einer mit Stickstoff gesättigten Mischung aus 134 mmol eines Benzolboronsäurederivats, 19.5 g (133 mmol) 3-Bromthiophen, 149 g (318 mmol) Na₂CO₃, 300 mL Dioxan und 150 mL Wasser wurden 1.3 g (1.16 mmol, 0.065 eq.) Pd(PPh₃)₄ gegeben, und die Suspension wurde 7 h auf 80 °C erhitzt. Danach wurden 0.08 g NaCN zugegeben und die wässrige Phase abgetrennt. Die organische Phase wurde zweimal mit H₂O gewaschen und anschließend über Na₂SO₄ getrocknet.

### 3-[3',5'-Bis(trifluormefhyl)phenyl]-thiophen

Nach Entfernen des Lösemittels und zweimaliger Umkristallisation aus CH₂Cl₂/MeOH erhielt man weiße Nadeln, die nach HPLC eine Reinheit von 98.9 % aufwiesen. Die Ausbeute betrug 18 g (80 %).

¹H-NMR (CDCl₃, 500 MHz): [ppm]= 7.40 (dd, ²J = 5.0 Hz, ³J = 1.3 Hz, 1H), 7.47 (dd, ²J = 5.0 Hz, ³J = 3.0 Hz, 1H), 7.52 (dd, ²J = 3.0 Hz, ³J = 1.3 Hz, 1H) 7.78 (s, 1H), 7.79 (s, 2H).

### Beispiel 4: Synthese von 3-Aryl-substituierten 2-Bromthiophenderivaten

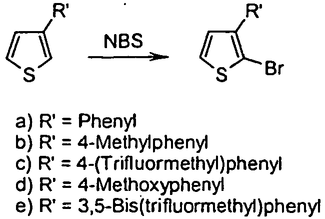

Die Synthese von 2-Brom-3-phenylthiophen und 2-Brom-3-(4'-methylphenyl)-thiophen ist beschrieben in J. Org. Chem. 2000, 65, 352-359. Die Synthese von 2-Brom-3-(4'-methoxyphenyl)-thiophen und 2-Brom-3-[4'-(trifluoromethyl)phenyl]-thiophen ist beschrieben in J. Org. Chem. 2002, 67, 457-469.

### Allgemeine Vorschrift:

Zu einer Lösung von 64 mmol des 3-Arylthiophenderivats in 250 mL DMF wurden bei RT in einer Schutzgasatmosphäre und unter Lichtausschluss 11.3 g (64 mmol) N-Bromsuccinimid innerhalb 15 min. zugegeben. Die Mischung wurde 6 h gerührt, anschließend wurden 100 mL gesättigte Na₂CO₃-Lösung zugegeben, die organische Phase abgetrennt und über Na₂SO₄ getrocknet.

### 2-Brom-3-[3'-5'-bis(trifluormethyl)phenyl]-thiophen

Nach dem Entfernen des Lösemittels und zweimaliger Umkristallisation aus Hexan erhielt man weiße Nadeln, die nach HPLC eine Reinheit von 98.7 % aufwiesen. Die Ausbeute betrug 14 g (87 %).

¹H-NMR (CDCl₃, 500 MHz): [ppm]= 7.08 (d, ²J = 5.6 Hz, 1H), 7.39 (d, ²J = 5.6 Hz, 1H) 7.87 (s, 1H), 8.01 (s, 2H).

### Beispiel 5: Synthese von 3'-Aryl-substituiertem 1,4-Bis(2'-thienyl)benzol

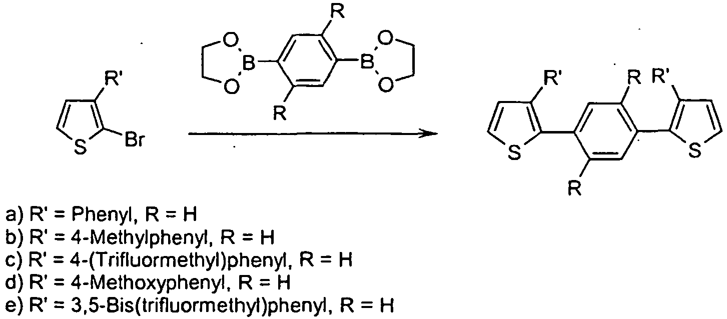

### Allgemeine Vorschrift:

Zu einer mit Stickstoff gesättigten Mischung aus 21.1 g (67 mmol) Benzoyl-1,4-bis(boronsäureglycolester), 133 mmol des 2-Brom-3-arylthiophenderivats, 33.6 g (318 mmol) Na₂CO₃, 300 mL Dioxan und 150 mL Wasser wurden 1.34 g (1.16 mmol) Pd(PPh₃)₄ gegeben und die Suspension 7 h auf 80 °C erhitzt. Danach wurden 0.08 g NaCN zugegeben und die wässrige Phase abgetrennt. Die organische Phase wurde zweimal mit H₂O gewaschen und anschließend über Na₂SO₄ getrocknet.

### 1,4-Bis(3'-Phenyl-2'-thienyl)benzol

Nach Entfernen des Lösemittels und zweimaliger Umkristallisation aus Hexan erhielt man gelbe Nadeln, die nach HPLC eine Reinheit von 97.9 % aufwiesen. Die Ausbeute betrug 22 g (85 %).

¹H-NMR (CDCl₃, 500 MHz): [ppm]= 7.13 (d, ²J = 5.3 Hz, 2H), 7.19 (s, 4H), 7.23 (t, ²J = 2.6 Hz, 2H), 7.28 (m, 8H), 7.31 (d, ²J = 5.3 Hz, 2H).

### Beispiel 6: Synthese von 3'-Aryl-substituiertem 1,4-Bis(5'-brom-2'thienyl)benzol

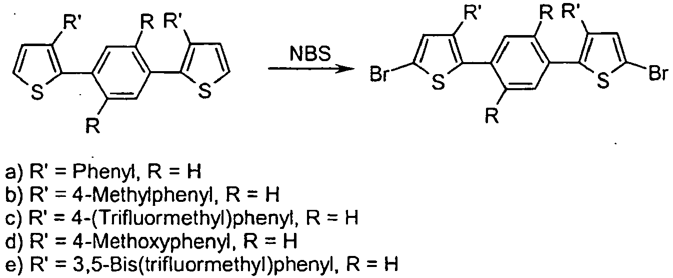

Die Bromierung der Verbindungen aus Beispiel 5 wurde analog der Bromierungsvorschrift aus Beispiel 2 durchgeführt.

### 1,4-Bis(5'-brom-3'-phenyl-2'-thienyl)benzol (Monomer T5)

Nach zweimaliger Umkristallisation aus Methanol erhielt man gelbe Kristalle, die nach HPLC eine Reinheit von 99.9 % aufwiesen. Die Ausbeute betrug 10 g (92 %).

¹H-NMR (CDCl₃, 500 MHz): [ppm]= 7.15 (s, 2H), 7.20 (s, 4H), 7.23 (t, ²J = 2.6 Hz, 2H), 7.28 (m, 8H).

### Beispiel 6: Synthese weiterer Comonomere

Die Strukturen der Monomere gemäß Formel (1) und weiterer Comonomere für erfindungsgemäße Polymere und Vergleichspolymere sind im Folgenden abgebildet. Die Synthese dieser Verbindungen ist in WO 03/020790 beschrieben.

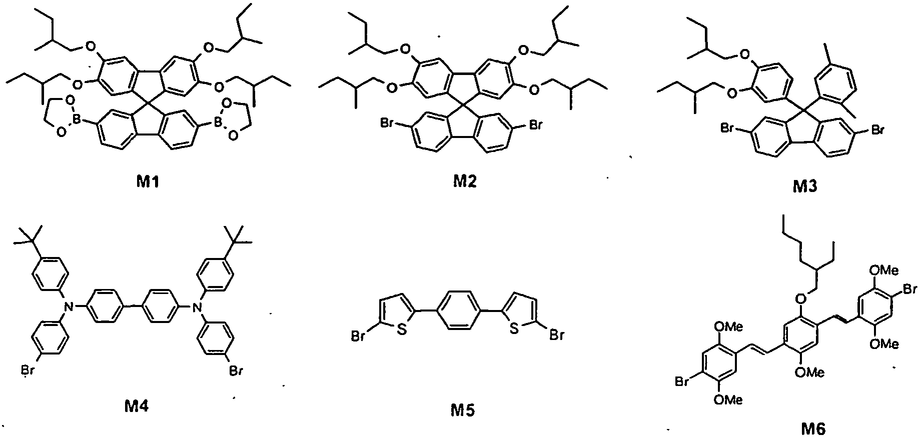

### Beispiel 7: Polymersynthese

Die Polymere wurden durch SUZUKI-Kupplung gemäß WO 03/048225 synthetisiert. Die Zusammensetzung der synthetisierten Polymere **P1** bis **P4** (Beispiele **8** bis **11**) ist in Tabelle 1 zusammengefasst. Ebenso wurden Vergleichspolymere (Beispiele **12** bis **14**; im Folgenden mit **V** bezeichnet) synthetisiert, die statt Einheiten gemäß Formel (2) Monomer **M5** bzw. Monomer **M6** als grün emittierende Einheiten gemäß dem Stand der Technik enthalten.

### Beispiel 15: Herstellung der PLEDs

Alle Polymere wurden für einen Einsatz in PLEDs untersucht. Diese PLEDs waren jeweils Zweischichtsysteme, d. h. Substra//ITO//PEDOT//Polymer//Kathode. PEDOT ist ein Polythiophen-Derivat (Baytron P von H. C. Starck, Goslar). Als Kathode wurde in allen Fällen Ba/Ag (von Aldrich) verwendet. Wie PLEDs dargestellt werden können, ist in WO 04/037887 und der darin zitierten Literatur ausführlich beschrieben.

Die wichtigsten Device-Eigenschaften der erfindungsgemäßen Polymere (Farbe, Effizienz, Betriebsspannung, Lebensdauer) sind in Tabelle 1 aufgeführt und sind den Vergleichspolymeren gegenübergestellt, die keine Einheiten gemäß Formel (2) enthalten.

**Tabelle 1: Eigenschaften von erfindungsgemäßen Polymeren und deren Vergleich mit Polymeren gemäß Stand der Technik; alle Polymere wurden über eine Suzuki-Polymerisation hergestellt.**

| | | Anteil der Monomere in der Polymerisation in % | | | | | | | GPC* | | Elektrolumineszenz | | | | |
|---|---|---|---|---|---|---|---|---|---|---|---|---|---|---|---|
| Erfindungsgemäße Polymere mit Einheiten gemäß Formel (1) und (2) | | | | | | | | | | | | | | | |
| Bsp. | Polymer Nr. | Monomer gemäß Formel (2) | M1 | M2 | M3 | M4 | M5 | M6 | M_{w} (· 1000 g/mol) | M_{N} (· 1000 g/mol) | λₘₐₓ [nm] | Max. Eff. [cd/A] | U bei 100 cd/m² [V] | CIE x/y | Lebensdauer bei 100 cd/m² [h] |
| 8 | P1 | 30 T3 | 50 | - | 10 | 10 | - | - | 593 | 89 | 512/ 541 | 9.9 | 2.7 | 0.34/0.59 | > 6000 |
| 9 | P2 | 30 T2 | 50 | - | 10 | 10 | - | - | 130 | 48 | 540 | 9.9 | 2.7 | 0.35/0.58 | > 6000 |
| 10 | P3 | 30 T1 | 50 | - | 10 | 10 | - | - | 378 | 120 | 539 | 9.7 | 2.6 | 0.35/0.57 | > 6000 |
| 11 | P4 | 30 T5 | 50 | - | 10 | 10 | - | - | 152 | 57 | 493/ 523 | 10.1 | 2.6 | 0.25/0.52 | > 7000 |

| Vergleichspolymere, die keine Einheiten gemäß Formel (2) enthalten | | | | | | | | | | | | | | | |
|---|---|---|---|---|---|---|---|---|---|---|---|---|---|---|---|
| 12 | V1 | - | 50 | - | 20 | 10 | - | 20 | 497 | 140 | 505/ 535 | 9.8 | 3.3 | 0.29/0.57 | > 5000 |
| 13 | V2 | - | 50 | - 20 | 20 | 10 | 20 | - | 577 | 96 | 492/ 524 | 9.7 | 3.2 | 0.25/0.53 | 4500 |
| 14 | V3 | - | 50 | - | 10 | 10 | 30 | - | 253 | 54 | 493/ 525 | 8.4 | 2.7 | 0.27/0.56 | 4700 |

| | | | | | | | | | | | | | | | |
|---|---|---|---|---|---|---|---|---|---|---|---|---|---|---|---|
| * GPC Messungen: THF; 1 mL/min. Plgel 10µm Mixed-B 2 x 300 x 7.5 mm², 35 °C, RI Detektion wurde gegen Polystyrol geeicht. | | | | | | | | | | | | | | | |

### Beispiel 16: Vergleich der Viskosität der Polymerlösungen

Die Viskosität einiger Polymerlösungen mit substituierten und unsubstituierten Dithienylarylen-Einheiten wurde untersucht. Die Ergebnisse sind in Tabelle 2 gezeigt.

**Tabelle 2: Viskositäten von Polymerlösungen in o-Xylol mit erfindungsgemäßen Polymeren und Vergleichspolymeren bei unterschiedlichen Temperaturen**

| Polymer | M_{w} (· 1000 g/mol) | Konz. [g/L] | η [mPa·s] 10 °C | η [mPa·s] 20 °C | η [mPa·s] 30 °C |
|---|---|---|---|---|---|
| P1 | 593 | 10 | 5.16 | 4.46 | 3.92 |
| P3 | 378 | 10 | 41.20 | 18.21 | 9.86 |
| V3 | 253 | 8 | 3753 | 422 | 63 |

Es ist offensichtlich, dass die erfindungsgemäßen Polymere eine vielfach geringere Viskosität haben als Polymere gemäß dem Stand der Technik, die unsubstituierte Dithienylarylen-Einelleiten enthalten. Dies wird umso deutlicher, als die hier untersuchten Polymere **P1** und **P3** ein (teilweise deutlich) höheres Molekulargewicht haben als das Vergleichspolymer **V3** und die Viskosität mit dem Molekulargewicht zunimmt. Außerdem war die Konzentration des Vergleichspolymers geringer als die der erfindungsgemäßen Polymere, und die Viskosität einer Polymerlösung steigt mit steigender Konzentration. Wenn man zusätzlich diese Aspekte mit einbezieht, lässt sich daraus schließen, dass der Effekt noch ausgeprägter ist, wenn Polymere gleichen Molekulargewichts in Lösungen gleicher Konzentration verglichen werden. Die Viskosität des Vergleichspolymers ist eindeutig zu hoch; dadurch eignet sich dieses Polymer nicht für eine problemlose Herstellung von PLEDs, insbesondere durch Tintenstrahldruck, wofür eine geeignete Lösungsviskosität von ca. 4 bis 25 mPa·s angegeben wird.

### Beispiel 17: Vergleich der Luftstabilität der Polymere

Mit Polymer **P1** und Vegleichspolymer **V1** wurden PLEDs hergestellt, einerseits in einer Stickstoff-Atmosphäre, andererseits an der Luft, und die Elektrolumineszenz der so erhaltenen Devices wurde untersucht: Die Ergebnisse sind in Tabelle 3 zusammengefasst.

**Tabelle 3: Vergleich der Effizienz von PLEDs, die unter Stickstoff oder an der Luft hergestellt wurden.**

| Polymer | Herstellung | Max. Eff. [cd/A] |
|---|---|---|
| **P1** | N₂ | 9.9 |
| **P1** | Luft | 9.6 |
| **V1** | N₂ | 9.8 |
| **V1** | Luft | 0.77 |

Wie leicht aus diesen Daten ersichtlich ist, lässt sich das erfindungsgemäße Polymer problemlos an der Luft ohne erhebliche Verschlechterung der Elektrolumineszenzeigenschaften verarbeiten, während das Vergleichspolymer V1 gemäß dem Stand der Technik unter gleichen Herstellungsbedingungen eine um mehr als eine Größenordnung geringere maximale Effizienz zeigt. Es ist also offensichtlich, dass die erfindungsgemäßen Polymere geeignet sind, den Herstellungsprozess von PLEDs zu vereinfachen, indem keine Herstellung unter inerten Bedingungen notwendig ist.

### Beispiel 18: Spannung und Spannungsanstieg bei Betrieb

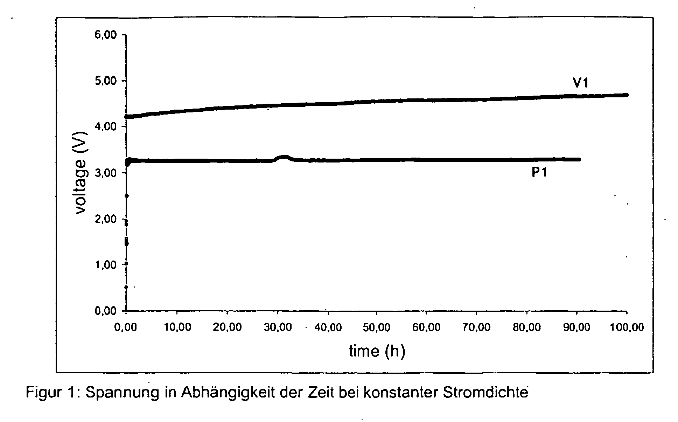

Mit Polymer P1 und Vergleichspolymer V1 wurden PLEDs hergestellt, und die Betriebsspannung wurde bei Betrieb der Vorrichtungen mit einer konstanten Stromdichte von 10 mA/cm² verfolgt. Die Änderung der Betriebsspannung mit der Zeit ist in Figur 1 dargestellt.

Wie leicht aus der Figur ersichtlich, ist die Spannung, die für eine Stromdichte von 10 mA/cm² benötigt wird, für das erfindungsgemäße Polymer **P1** deutlich geringer als für das Vergleichspolymer **V1**. Weiterhin erkennt man aus der Figur, dass der Spannungsanstieg bei dem erfindungsgemäßen Polymer deutlich niedriger und sogar beinahe gleich Null ist, während er bei dem Vergleichspolymer deutlich höher ist. Dies ist ein wichtiges Ergebnis, da es zeigt, dass das erfindungsgemäße Polymer stabiler gegenüber Strom ist als das Vergleichspolymer.

## Patentansprüche

1. Polymere, enthaltend mindestens 5 mol% Einheiten gemäß Formel (1), 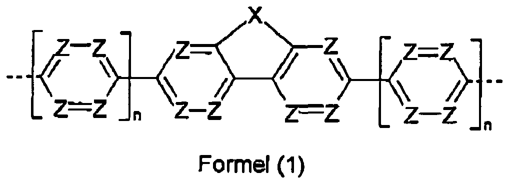 wobei die verwendeten Symbole folgende Bedeutung besitzen:
X ist bei jedem Auftreten gleich oder verschieden CR₂, N(R¹), -CR₂-CR₂- oder -N(R¹)-CR₂-;
Z ist bei jedem Auftreten gleich oder verschieden CR oder N;
R ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch N(R¹), -O-, -S-, -O-CO-O-, -CO-O-, C=O, -C(R¹)=C(R¹)- oder -C≡C- ersetzt sein können, wobei auch ein oder mehrere H-Atome durch Fluor oder einen aromatischen Rest R¹ ersetzt sein können, ein aromatisches oder heteroaromatisches Ringsystem oder eine Aryloxygruppe mit 5 bis 40 C-Atomen, bei denen auch ein oder mehrere C-Atome durch O S oder N ersetzt sein können und welche auch durch einen oder mehrere nicht-aromatische Reste R substituiert sein können, wobei auch zwei oder mehrere der Reste R miteinander ein aromatisches oder aliphatisches, mono- oder polycyclisches Ringsystem bilden können, oder Fluor, Chlor, CN, N(R¹)₂, Si(R¹)₃ oder B(R¹)₂;
R¹ ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, -O-CO-O-, C=O, -CH=CH- oder -C≡C- ersetzt sein können, wobei auch ein oder mehrere H-Atome durch Fluor ersetzt sein können, eine Aryl-, Heteroaryl - oder Aryloxygruppe mit 5 bis 40 C-Atomen, bei der auch ein oder mehrere C-Atome durch O, S oder N ersetzt sein können, welche auch durch einen oder mehrere nicht-aromatische Reste R¹ substituiert sein können, wobei auch ein oder mehrere Reste R¹ oder R¹ mit weiteren Resten R miteinander ein aromatisches oder aliphatisches, mono- oder polycyclische Ringsystem bilden kann;
n ist bei jedem Auftreten gleich oder verschieden 0 oder 1;
**dadurch gekennzeichnet, dass** das Polymer weiterhin mindestens 0.01 mol% Einheiten gemäß Formel (2) enthält, 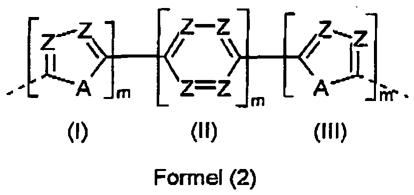 wobei für die Symbole und Indizes Folgendes gilt:
A ist bei jedem Auftreten gleich oder verschieden S, O oder N(R¹);
Z ist bei jedem Auftreten gleich oder verschieden CR oder N, mit der Maßgabe, dass die zentrale Einheit (II) kein Chinoxalin, kein Benzothiadiazol und kein unsubstituiertes Anthracen beschreibt und mit der weiteren Maßgabe, dass mindestens ein Rest R ungleich Wasserstoff ist;
R ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch N(R¹). -O-, -S-, -O-CO-O-, -CO-O-, C=O, -C(R¹)=C(R¹)- oder -C≡C- ersetzt sein können, wobei auch ein oder mehrere H-Atome durch Fluor oder einen aromatischen Rest R¹ ersetzt sein können, ein aromatisches oder heteroaromatisches Ringsystem oder eine Aryloxygruppe mit 5 bis 40 C-Atomen, bei denen auch ein oder mehrere C-Atome durch O, S oder N ersetzt sein können und welche auch durch einen oder mehrere nicht-aromatische Reste R substituiert sein können, wobei auch zwei oder mehrere der Reste R miteinander ein aliphatisches, mono- oder polycyclisches Ringsystem bilden können, oder Fluor, Chlor, CN, N(R¹)₂, Si(R¹)₃ oder B(R¹)₂;
m ist bei jedem Auftreten gleich oder verschieden 1, 2 oder 3;
die weiteren Symbole sind wie unter Formel (1) beschrieben;
die gestrichelte Bindung bedeutet dabei in Formel (1) und Formel (2) ebenso wie in allen weiteren Formeln die Verknüpfung im Polymer.

2. Polymere gemäß Anspruch 1, **dadurch gekennzeichnet, dass** sie konjugiert sind.

3. Polymer gemäß Anspruch 1 und/oder 2, **dadurch gekennzeichnet, dass** es noch weitere Strukturelemente enthält.

4. Polymer gemäß Anspruch 3, **dadurch gekennzeichnet, dass** die weiteren Strukturelemente die Lochinjektions- und/oder -transporteigenschaften des Polymers erhöhen.

5. Polymer gemäß Anspruch 4, **dadurch gekennzeichnet, dass** diese Strukturelemente ausgewählt sind aus den Klassen der Triarylaminderivate, Benzidinderivate, Tetraarylen-para-phenylendiaminderivate, Phenothiazinderivate, Phenoxazinderivate, Dihydrophenazinderivate, Thianthrenderivate, Dibenzo-p-dioxinderivate, Phenoxathiinderivate, Carbazolderivate, Azulenderivate, Thiophenderivate, Pyrrolderivate oder Furanderivate.

6. Polymere gemäß einem oder mehreren der Ansprüche 1 bis 5, **dadurch gekennzeichnet, dass** die weiteren Strukturelemente die Elektroneninjektions- und/oder -transporteigenschaften des Polymers erhöhen.

7. Polymere gemäß Anspruch 6, **dadurch gekennzeichnet, dass** diese Strukturelemente ausgewählt sind aus den Klassen der Pyridinderivate, Pyrimidinderivate, Pyridazinderivate, Pyrazinderivate, Triazinderivate, Anthracenderivate, Oxadiazolderivate, Benzothiadiazolderivate, Chinolinderivate, Chinoxalinderivate, Phenazinderivate oder Triarylborane.

8. Polymere gemäß einem oder mehreren der Ansprüche 1 bis 7, **dadurch gekennzeichnet, dass** die weiteren Strukturelemente Kombinationen von Einzeleinheiten gemäß Anspruch 4 und/oder 5 und Einzelelementen gemäß Anspruch 6 und/oder 7 aufweisen.

9. Polymere gemäß einem oder mehreren der Ansprüche 1 bis 8, **dadurch gekennzeichnet, dass** die weiteren Strukturelemente die Morphologie oder gegebenenfalls auch die Emissionsfarbe der Polymere beeinflussen.

10. Polymere gemäß Anspruch 9, **dadurch gekennzeichnet, dass** diese Strukturelemente ausgewählt sind aus den Klassen der 1,4-Phenylen-, 1,4-Naphthylen-, 1,4- oder 9,10-Anthrylen-, 1,6- oder 2,7- oder 4,9-Pyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 5,7-Dihydrodibenzooxepinylen-, 4,4'-Stilbenylen- oder 4,4"-Bisstyrylarylenderivate.

11. Polymere gemäß einem oder mehreren der Ansprüche 1 bis 10, **dadurch gekennzeichnet, dass** mindestens ein weiteres Strukturelement anwesend ist, das Ladungstransporteigenschaften aufweist.

12. Polymere gemäß einem oder mehreren der Ansprüche 1 bis 11, **dadurch gekennzeichnet, dass** für Struktureinheiten gemäß Formel (1) Z = CR, insbesondere Z = CH gilt.

13. Polymere gemäß Anspruch 12, **dadurch gekennzeichnet, dass** die Struktureinheiten gemäß Formel (1) ausgewählt sind aus den Gruppen der Fluorene gemäß Formel (3), der durch einen C₁ bis C₄₀ organischen Rest substituierten oder unsubstituierten 9,9'-Spirobifluorene gemäß Formel (4), der Dihydrophenanthrene gemäß Formel (5), der trans-Indenofluorene gemäß Formel (6) oder der cis-Indenofluorene gemäß Formel (7), wobei die verwendeten Symbole dieselbe Bedeutung haben, wie unter Anspruch 1 definiert:

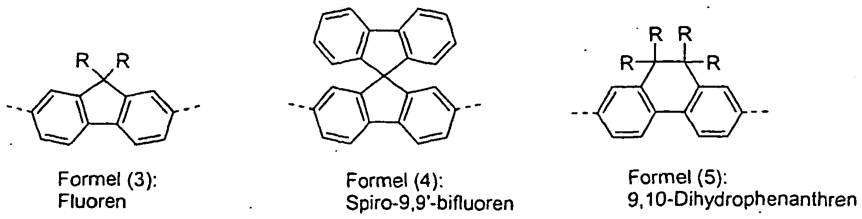

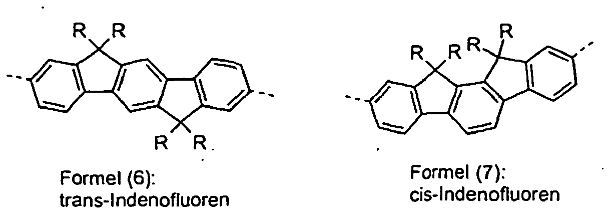

14. Polymere gemäß einem oder mehreren der Ansprüche 1 bis 13, **dadurch gekennzeichnet, dass** für Einheiten gemäß Formel (2) gilt:
Z ist bei jedem Auftreten gleich oder verschieden CR, wobei die in Anspruch 1 genannten Einschränkungen weiterhin gelten;
A ist bei jedem Auftreten gleich oder verschieden O oder S;
m ist bei jedem Auftreten gleich oder verschieden 1 oder 2;
die weiteren Symbole sind wie unter Anspruch 1 definiert.

15. Polymere gemäß Anspruch 14, **dadurch gekennzeichnet, dass** für Einheiten gemäß Formel (2) gilt:
Z ist bei jedem Auftreten gleich oder verschieden CR, wobei die in Anspruch 1 genannten Einschränkungen weiterhin gelten und mindestens zwei Reste R ungleich Wasserstoff sind;
A ist bei jedem Auftreten gleich S;
R ist wie unter Anspruch 1 definiert;
R¹ ist wie unter Anspruch 1 definiert;
m ist bei jedem Auftreten gleich 1.

16. Polymer gemäß einem oder mehreren der Ansprüche 1 bis 15, **dadurch gekennzeichnet, dass** der Anteil an Struktureinheiten gemäß Formel (1) mindestens 10 mol% und der Anteil an Struktureinheiten gemäß Formel (2) mindestens 5 mol% beträgt.

17. Mischung (Blend) mindestens eines Polymers gemäß einem oder mehreren der Ansprüche 1 bis 16 mit weiteren polymeren, oligomeren, dendritischen oder niedermolekularen Substanzen.

18. Lösungen und Formulierungen aus einem oder mehreren Polymeren oder Blends gemäß einem oder mehreren der Ansprüche 1 bis 17 in einem oder mehreren Lösungsmitteln.

19. Verwendung eines Polymers oder Blends gemäß einem oder mehreren der Ansprüche 1 bis 17 in einer PLED.

20. PLED mit einer oder mehreren aktiven Schichten, wobei mindestens eine dieser Schichten ein oder mehrere Polymere oder Blends gemäß einem oder mehreren der Ansprüche 1 bis 17 enthält.

21. Verwendung von Polymeren oder Blends gemäß einem oder mehreren der Ansprüche 1 bis 17 in organischen Feld-Effekt-Transistoren (OFETs), in organischen Dünnfilmtransistoren (OTFTs), in organischen integrierten Schaltungen (O-ICs), in organischen Solarzellen (O-SCs) oder organischen Laserdioden (O-Laser).

22. Organische Feld-Effekt-Transistoren (OFETs), organische Dünnfilmtransistoren (OTFTs), organische integrierte Schaltungen (O-ICs), organische Solarzellen (O-SCs) oder organische Laserdioden (O-Laser) enthaltend ein oder mehrere Polymere oder Blends gemäß einem oder mehreren der Ansprüche 1 bis 17.

## Claims

1. Polymers containing at least 5 mol% of units of the formula (1), 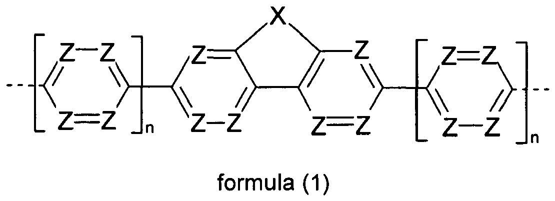 where the symbols used have the following meaning:
X is on each occurrence, identically or differently, CR₂, N(R¹), -CR₂-CR₂- or -N(R¹)-CR₂-;
Z is on each occurrence, identically or differently, CR or N;
R is on each occurrence, identically or differently, H, a straight-chain, branched or cyclic alkyl or alkoxy chain having 1 to 22 C atoms, in which, in addition, one or more non-adjacent C atoms may be replaced by N(R¹), -O-, -S-, -O-CO-O-, -CO-O-, C=O, -C(R¹)=C(R¹)- or -C≡C-, where, in addition, one or more H atoms may be replaced by fluorine or an aromatic radical R¹, an aromatic or heteroaromatic ring system or an aryloxy group having 5 to 40 C atoms, in which, in addition, one or more C atoms may be replaced by O, S or N and which may also be substituted by one or more non-aromatic radicals R, where, in addition, two or more of the radicals R may form an aromatic or aliphatic, mono- or polycyclic ring system with one another, or fluorine, chlorine, CN, N(R¹)₂, Si(R¹)₃ or B(R¹)₂;
R¹ is on each occurrence, identically or differently, H, a straight-chain, branched or cyclic alkyl chain having 1 to 22 C atoms, in which, in addition, one or more non-adjacent C atoms may be replaced by O, S, -CO-O-, -O-CO-O-, C=O, -CH=CH- or -C≡C-, where, in addition, one or more H atoms may be replaced by fluorine, an aryl, heteroaryl or aryloxy group having 5 to 40 C atoms, in which, in addition, one or more C atoms may be replaced by O, S or N, which may also be substituted by one or more non-aromatic radicals R¹, where, in addition, one or more radicals R¹ or R¹ with further radicals R may form an aromatic or aliphatic, mono- or polycyclic ring system with one another;
n is on each occurrence, identically or differently, 0 or 1;
**characterised in that** the polymer furthermore contains at least 0.01 mol% of units of the formula (2), 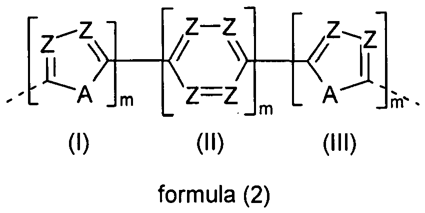 where the following applies to the symbols and indices:
A is on each occurrence, identically or differently, S, O or N(R¹);
Z is on each occurrence, identically or differently, CR or N, with the proviso that the central unit (II) does not describe quinoxaline, benzothiadiazole or unsubstituted anthracene and with the further proviso that at least one radical R is not equal to hydrogen;
R is on each occurrence, identically or differently, H, a straight-chain, branched or cyclic alkyl or alkoxy chain having 1 to 22 C atoms, in which, in addition, one or more non-adjacent C atoms may be replaced by N(R¹), -O-, -S-, -O-CO-O-, -CO-O-, C=O, -C(R¹)=C(R¹)- or -C≡C-, where, in addition, one or more H atoms may be replaced by fluorine or an aromatic radical R¹, an aromatic or heteroaromatic ring system or an aryloxy group having 5 to 40 C atoms, in which, in addition, one or more C atoms may be replaced by O, S or N and which may also be substituted by one or more non-aromatic radicals R, where, in addition, two or more of the radicals R may form an aliphatic, mono- or polycyclic ring system with one another, or fluorine, chlorine, CN, N(R¹)₂, Si(R¹)₃ or B(R¹)₂;
m is on each occurrence, identically or differently, 1, 2 or 3;
the other symbols are as described under formula (1);
the dashed bond in formula (1) and formula (2) and also in all other formulae denotes the linking in the polymer.

2. Polymers according to Claim 1, **characterised in that** they are conjugated.

3. Polymer according to Claim 1 and/or 2, **characterised in that** it contains further structural elements.

4. Polymer according to Claim 3, **characterised in that** the further structural elements enhance the hole-injection and/or -transport properties of the polymer.

5. Polymer according to Claim 4, **characterised in that** these structural elements are selected from the classes of the triarylamine derivatives, benzidine derivatives, tetra-arylene-para-phenylenediamine derivatives, phenothiazine derivatives, phenoxazine derivatives, dihydrophenazine derivatives, thianthrene derivatives, dibenzo-p-dioxin derivatives, phenoxathiyne derivatives, carbazole derivatives, azulene derivatives, thiophene derivatives, pyrrole derivatives or furan derivatives.

6. Polymers according to one or more of Claims 1 to 5, **characterised in that** the further structural elements enhance the electron-injection and/or -transport properties of the polymer.

7. Polymers according to Claim 6, **characterised in that** these structural elements are selected from the classes of the pyridine derivatives, pyrimidine derivatives, pyridazine derivatives, pyrazine derivatives, triazine derivatives, anthracene derivatives, oxadiazole derivatives, benzothiadiazole derivatives, quinoline derivatives, quinoxaline derivatives, phenazine derivatives or triarylboranes.

8. Polymers according to one or more of Claims 1 to 7, **characterised in that** the further structural elements contain combinations of individual units according to Claim 4 and/or 5 and individual elements according to Claim 6 and/or 7.

9. Polymers according to one or more of Claims 1 to 8, **characterised in that** the further structural elements influence the morphology or where appropriate also the emission colour of the polymers.

10. Polymers according to Claim 9, **characterised in that** these structural elements are selected from the classes of the 1,4-phenylene, 1,4-naphthylene, 1,4- or 9,10-anthrylene, 1,6- or 2,7- or 4,9-pyrenylene, 3,9- or 3,10-perylenylene, 2,7- or 3,6-phenanthrenylene, 4,4'-biphenylylene, 4,4"-terphenylylene, 4,4'-bi-1,1'-naphthylylene, 5,7-dihydrodibenzooxepinylene, 4,4'-stilbenylene or 4,4"-bisstyrylarylene derivatives.

11. Polymers according to one or more of Claims 1 to 10, **characterised in that** at least one further structural element is present which has charge-transport properties.

12. Polymers according to one or more of Claims 1 to 11, **characterised in that** Z = CR, in particular Z = CH, for structural units of the formula (1).

13. Polymers according to Claim 12, **characterised in that** the structural units of the formula (1) are selected from the groups of the fluorenes of the formula (3), the 9,9'-spirobifluorenes of the formula (4) which are substituted by a C₁ to C₄₀ organic radical or unsubstituted, the dihydrophenanthrenes of the formula (5), the trans-indenofluorenes of the formula (6) or the cis-indenofluorenes of the formula (7), where the symbols used have the same meaning as defined under Claim 1:

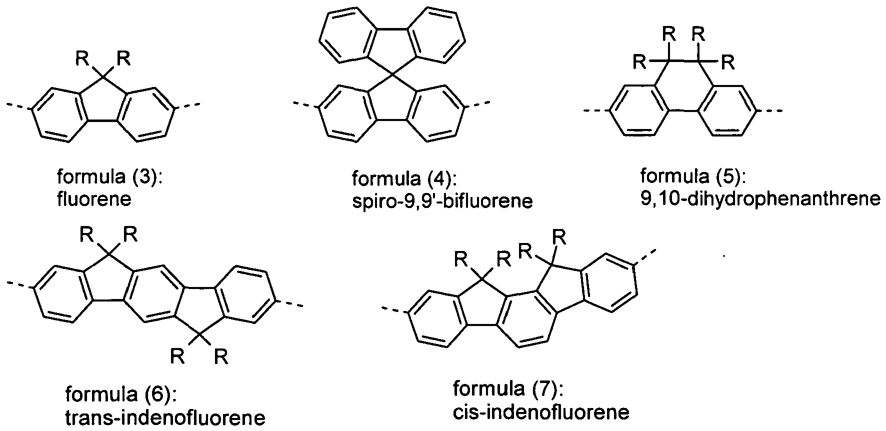

14. Polymers according to one or more of Claims 1 to 13, **characterised in that**, for units of the formula (2):
Z is on each occurrence, identically or differently, CR, where the restrictions mentioned in Claim 1 furthermore apply;
A is on each occurrence, identically or differently, O or S;
m is on each occurrence, identically or differently, 1 or 2;
the other symbols are as defined under Claim 1.

15. Polymers according to Claim 14, **characterised in that**, for units of the formula (2):
Z is on each occurrence, identically or differently, CR, where the restrictions mentioned in Claim 1 furthermore apply and at least two radicals R are not equal to hydrogen;
A is on each occurrence equal to S;
R is as defined under Claim 1;
R¹ is as defined under Claim 1;
m is on each occurrence equal to 1.

16. Polymer according to one or more of Claims 1 to 15, **characterised in that** the proportion of structural units of the formula (1) is at least 10 mol% and the proportion of structural units of the formula (2) is at least 5 mol%.

17. Mixture (blend) of at least one polymer according to one or more of Claims 1 to 16 with further polymeric, oligomeric, dendritic or low-molecular-weight substances.

18. Solutions and formulations of one or more polymers or blends according to one or more of Claims 1 to 17 in one or more solvents.

19. Use of a polymer or blend according to one or more of Claims 1 to 17 in a PLED.

20. PLED having one or more active layers, where at least one of these layers comprises one or more polymers or blends according to one or more of Claims 1 to 17.

21. Use of polymers or blends according to one or more of Claims 1 to 17 in organic field-effect transistors (OFETs), in organic thin-film transistors (OTFTs), in organic integrated circuits (O-ICs), in organic solar cells (O-SCs) or organic laser diodes (O-lasers).

22. Organic field-effect transistors (OFETs), organic thin-film transistors (OTFTs), organic integrated circuits (O-ICs), organic solar cells (O-SCs) or organic laser diodes (O-lasers) comprising one or more polymers or blends according to one or more of Claims 1 to 17.

## Revendications

1. Polymères contenant au moins 5 %mol d'unités de la formule (1), 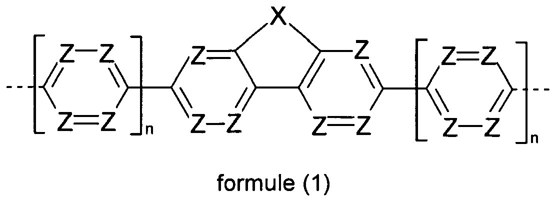 dans laquelle the symboles utilisés présentent la signification qui suit :
X est, pour chaque occurrence, de manière identique ou différente, CR₂, N(R¹), -CR₂-CR₂- or -N(R¹)-CR₂- ;
Z est, pour chaque occurrence, de manière identique ou différente, CR ou N;
R est, pour chaque occurrence, de manière identique ou différente, H, une chaîne alkyle ou alcoxy en chaîne droite, ramifiée ou cyclique comportant de 1 à 22 atomes de C, où, en outre, un ou plusieurs atomes de C non adjacents peut/peuvent être remplacé(s) par N(R¹), -O-, -S-, -O-CO-O-, -CO-O-, C=O, -C(R¹)=C(R¹)- ou -C≡C-, où, en outre, un ou plusieurs atomes de H peut/peuvent être remplacé(s) par fluor ou un radical aromatique R¹, un système de cycle aromatique ou hétéroaromatique ou un groupe aryloxy comportant de 5 à 40 atomes de C, où, en outre, un ou plusieurs atomes de C peut/peuvent être remplacé(s) par O, S ou N et lequel ou lesquels peut/peuvent également être substitué(s) par un ou plusieurs radicaux R non aromatiques, où, en outre, deux des radicaux R ou plus peuvent former un système de cycle aromatique ou aliphatique, mono- ou polycyclique l'un avec l'autre ou les uns avec les autres, ou fluor, chlore, CN, N(R¹)₂, Si(R¹)₃ ou B(R¹)_{2;}
R¹ est, pour chaque occurrence, de manière identique ou différente, H, une chaîne alkyle en chaîne droite, ramifiée ou cyclique comportant de 1 à 22 atomes de C, où, en outre, un ou plusieurs atomes de C non adjacents peut/peuvent être remplacé(s) par O, S, -CO-O-, -O-CO-O-, C=O, -CH=CH- ou -C≡C-, où, en outre, un ou plusieurs atomes de H peut/peuvent être remplacé(s) par fluor, un groupe aryle, hétéroaryle ou aryloxy comportant de 5 à 40 atomes de C, où, en outre, un ou plusieurs atomes de C peut/peuvent être remplacé(s) par O, S ou N, lequel ou lesquels peut/peuvent également être substitué(s) par un ou plusieurs radicaux R¹ non aromatiques où, en outre, un ou plusieurs radicaux R¹ ou R¹ avec d'autres radicaux R peut/peuvent former un système de cycle aromatique ou aliphatique, mono- ou polycyclique les uns avec les autres ;
n est, pour chaque occurrence, de manière identique ou différente, 0 ou 1;
**caractérisés en ce que** le polymère contient en outre au moins 0,01 %mol d'unités de la formule (2), 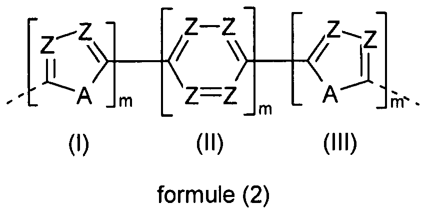 dans laquelle ce qui suit s'applique aux symboles et indices :
A est, pour chaque occurrence, de manière identique ou différente, S, O ou N(R¹) ;
Z est, pour chaque occurrence, de manière identique ou différente, CR ou N, étant entendu que l'unité centrale (II) ne décrit ni quinoxaline, ni benzothiadiazole, ni anthracène non substitué et étant entendu en outre qu'au moins un radical R n'est pas égal à hydrogène ;
R est, pour chaque occurrence, de manière identique ou différente, H, une chaîne alkyle ou alcoxy en chaîne droite, ramifiée ou cyclique comportant de 1 à 22 atomes de C, où, en outre, un ou plusieurs atomes de C non adjacents peut/peuvent être remplacé(s) par N(R¹), -O-, -S-, -O-CO-O-, -CO-O-, C=O, -C(R¹)=C(R¹)- ou -C≡C-, où, en outre, un ou plusieurs atomes de H peut/peuvent être remplacé(s) par fluor ou un radical aromatique R¹, un système de cycle aromatique ou hétéroaromatique ou un groupe aryloxy comportant de 5 à 40 atomes de C, où, en outre, un ou plusieurs atomes de C peut/peuvent être remplacé(s) par O, S ou N et lequel ou lesquels peut/peuvent également être substitué(s) par un ou plusieurs radicaux non aromatiques R, où, en outre, deux ou plus des radicaux R peuvent former un système de cycle aliphatique, mono- ou polycyclique l'un avec l'autre ou les uns avec les autres, ou fluor, chlore, CN, N(R¹)₂, Si(R¹)₃ ou B(R¹)_{2;}
m est, pour chaque occurrence, de manière identique ou différente, 1, 2 ou 3 ;
les autres symboles sont comme décrit sous la formule (1) ;
la liaison en pointillés dans la formule (1) et la formule (2) et également dans d'autres formules représente la liaison dans le polymère.

2. Polymères selon la revendication 1, **caractérisés en ce qu'**ils sont conjugués.

3. Polymère selon la revendication 1 et/ou 2, **caractérisé en ce qu'**il contient d'autres éléments structurels.

4. Polymère selon la revendication 3, **caractérisé en ce que** les autres éléments structurels améliorent les propriétés d'injection et/ou de transport de trous du polymère.

5. Polymère selon la revendication 4, **caractérisé en ce que** ces autres éléments structurels sont choisis parmi les classes des dérivés de triarylamine, des dérivés de benzidine, des dérivés de tétraarylène-*para*-phénylenediamine, des dérivés de phénothiazine, des dérivés de phénoxazine, des dérivés de dihydrophénazine, des dérivés de thianthrène, des dérivés de dibenzo-p-dioxine, des dérivés de phénoxathiyne, des dérivés de carbazole, des dérivés d'azulène, des dérivés de thiophène, des dérivés de pyrrole ou des dérivés de furane.

6. Polymères selon une ou plusieurs des revendications 1 à 5, **caractérisés en ce que** les autres éléments structurels améliorent les propriétés d'injection/de transport d'électrons du polymère.

7. Polymères selon la revendication 6, **caractérisés en ce que** ces éléments structurels sont choisis parmi les classes des dérivés de pyridine, des dérivés de pyrimidine, des dérivés de pyridazine, des dérivés de pyrazine, des dérivés de triazine, des dérivés d'anthracène, des dérivés d'oxadiazole, des dérivés de benzothiadiazole, des dérivés de quinoline, des dérivés de quinoxaline, des dérivés de phénazine ou des triarylboranes.

8. Polymères selon une ou plusieurs des revendications 1 à 7, **caractérisés en ce que** les autres éléments structurels contiennent des combinaisons d'unités individuelles selon la revendication 4 et/ou 5 et d'éléments individuels selon la revendication 6 et/ou 7.

9. Polymères selon une ou plusieurs des revendications 1 à 8, **caractérisés en ce que** les autres éléments structurels influencent la morphologie ou lorsqu'approprié, la couleur d'émission des polymères.

10. Polymères selon la revendication 9, **caractérisés en ce que** ces éléments structurels sont choisis parmi les classes des dérivés de 1,4-phénylène, 1,4-naphtylène, 1,4- ou 9,10-anthrylène, 1,6- ou 2,7- ou 4,9-pyrénylène, 3,9- ou 3,10-pérylènylène, 2,7- ou 3,6-phénanthrénylène, 4,4'-biphénylylène, 4,4"-terphénylylène, 4,4'-bi-1,1'-naphtylylène, 5,7-dihydrodibenzooxépinylène, 4,4'-stilbènylène ou 4,4"-bisstyrylarylène.

11. Polymères selon une ou plusieurs des revendications 1 à 10, **caractérisés en ce que** l'au moins un autre élément structurel est présent, lequel présente des propriétés de transport de charges.

12. Polymères selon une ou plusieurs des revendications 1 à 11, **caractérisés en ce que** Z = CR, en particulier Z = CH, pour des unités structurelles de la formule (1).

13. Polymères selon la revendication 12, **caractérisés en ce que** les unités structurelles de la formule (1) sont choisies parmi les groupes des fluorènes de la formule (3), les 9,9'-spirobifluorènes de la formule (4) qui sont substitués par un radical organique C₁ à C₄₀ ou non unsubstitués, les dihydrophénanthrènes de la formule (5), les trans-indénofluorènes de la formule (6) ou les cis-indénofluorènes de la formule (7), où les symboles utilisés présentent la même signification que défini sous la revendication 1 :

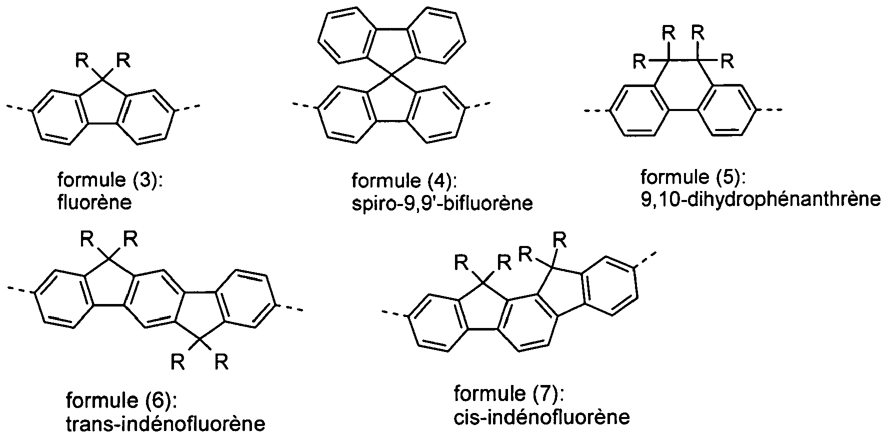

14. Polymères selon une ou plusieurs des revendications 1 à 13, **caractérisés en ce que**, pour des unités de la formule (2) :
Z est, pour chaque occurrence, de manière identique ou différente, CR, où les restrictions mentionnées selon la revendication 1 s'appliquent en outre ;
A est, pour chaque occurrence, de manière identique ou différente, O ou S ;
m est, pour chaque occurrence, de manière identique ou différente, 1 ou 2 ;
les autres symboles sont comme défini sous la revendication 1.

15. Polymères selon la revendication 14, **caractérisés en ce que**, pour des unités de la formule (2) :
Z est, pour chaque occurrence, de manière identique ou différente, CR, où les restrictions mentionnées selon la revendication 1 s'appliquent en outre et au moins deux radicaux R ne sont pas égaux à hydrogène ;
A est pour chaque occurrence égal à S ;
R est comme défini sous la revendication 1 ;
R¹ est comme défini sous la revendication 1 ;
m est pour chaque occurrence égal à 1.

16. Polymère selon une ou plusieurs des revendications 1 à 15, **caractérisé en ce que** la proportion d'unités structurelles de la formule (1) est d'au moins 10 %mol et la proportion d'unités structurelles de la formule (2) est d'au moins 5 %mol.

17. Mélange (association) d'au moins un polymère selon une ou plusieurs des revendications 1 à 16 avec d'autres substances polymériques, oligomériques, dendritiques ou de poids moléculaire faible.

18. Solutions et formulations d'un ou de plusieurs polymères ou mélanges selon une ou plusieurs des revendications 1 à 17 dans un ou plusieurs solvants.

19. Utilisation d'un polymère ou mélange selon une ou plusieurs des revendications 1 à 17 dans une PLED.

20. PLED comportant une ou plusieurs couches actives, où au moins l'une de ces couches comprend un ou plusieurs polymères ou mélanges selon une ou plusieurs des revendications 1 à 17.

21. Utilisation de polymères ou de mélanges selon une ou plusieurs des revendications 1 à 17 dans des transistors à effet de champ organiques (OFET), dans des transistors à film mince organiques (OTFT), dans des circuits intégrés organiques (O-IC), dans des cellules solaires organiques (O-SC) ou des diodes laser organiques (O-laser).

22. Transistors à effet de champ organiques (OFET), transistors à film mince organiques (OTFT), circuits intégrés organiques (O-IC), cellules solaires organiques (O-SCs) ou diodes laser organiques (O-laser) comprenant un ou plusieurs polymères ou mélanges selon une ou plusieurs des revendications 1 à 17.
